Europäisches Patentamt

**European Patent Office**

**Office européen des brevets**

(11) Numéro de publication: **0 063 502**
**B1**

(12) **FASCICULE DE BREVET EUROPEEN**

(45) Date de publication du fascicule du brevet:
**01.08.84**

(51) Int. Cl.³: **H 04 M 3/30,** G 01 R 31/08

(21) Numéro de dépôt: **82400337.0**

(22) Date de dépôt: **26.02.82**

(54) **Dispositif de localisation de défauts dans une ligne bifilaire.**

(30) Priorité: **17.04.81 FR 8107784**

(43) Date de publication de la demande:
**27.10.82 Bulletin 82/43**

(45) Mention de la délivrance du brevet:
**01.08.84 Bulletin 84/31**

(84) Etats contractants désignés:
**DE FR GB**

(56) Documents cités:
**EP - A - 0 003 433**
**DE - A - 1 219 096**
**DE - A - 1 416 618**
**DE - B - 2 620 348**
**FR - A - 2 416 478**
**FR - A - 2 481 032**
**GB - A - 1 333 667**
**US - A - 3 235 677**

(73) Titulaire: **Poitevin, Jean-Pierre, 53, rue Denis Gogue,**
**F-92140 Clamart (FR)**

(72) Inventeur: **Poitevin, Jean-Pierre, 53, rue Denis Gogue,**
**F-92140 Clamart (FR)**

(74) Mandataire: **Cabinet Martinet, 62, rue des Mathurins,**
**F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

La présente invention concerne un dispositif d'essai pour localiser des défauts dans une ligne bifilaire. Les défauts peuvent être d'un premier type, tels que des coupures, ou ruptures, ou ouvertures, ou fortes résistances série, et/ou d'un second type, tels que des courts-circuits, ou défauts d'isolement ou shunts à faible résistance entre l'un des fils de ligne et la terre ou entre les deux fils de la ligne.

Le brevet FR-A N° 2481032 et le brevet US-A N° 3235677 décrivent un dispositif de localisation de défauts — également appelé dispositif d'essai — comprenant, en outre, un premier dipôle en parallèle entre les deux fils d'une ligne de communication. Le premier dipôle comprend une résistance et une diode en série. L'une des extrémités de la ligne est reliée à une charge tandis que l'autre est reliée sélectivement à un appareil de mesure de résistances.

Les localisations de coupures s'effectuent par rapport au premier dipôle grâce à la détection d'un courant de fuite passant volontairement à travers la diode du premier dipôle. La présence d'une telle diode requiert non seulement une polarité prédéterminée des tensions de mesure, mais également des tensions opposées appliquées à l'extrémité de la ligne, lors de son exploitation normale. Cet inconvénient exige donc de veiller scrupuleusement au maintien de la polarité des tensions appliquées, en particulier lors des interventions sur la ligne.

En outre, les caractéristiques de ce dispositif d'essai le rendent incompatible avec la plupart des appareils d'essais et de mesures existants de lignes téléphoniques d'abonné et exigent des modifications ou adjonctions à ces appareils d'essais et de mesures que tout central téléphonique possède, exigences très coûteuses eu égard au nombre d'appareils concernés.

Par ailleurs, la distinction entre courant de fuite volontairement provoqué et courants de fuite naturels sur certaines lignes dont l'isolement n'est pas parfait est délicate et rend illusoire la localisation d'une ouverture d'une ligne équipée d'un tel dispositif d'essai.

La présente invention a donc pour but de fournir un dispositif de localisation de défauts, notamment tels que des coupures, qui n'exige aucune polarité prédéterminée des tensions appliquées à la ligne et qui est compatible avec les appareils d'essais et de mesures de lignes téléphoniques d'abonné, en ce qui concerne l'application particulière à la téléphonie.

A cette fin, un dispositif de localisation de défauts dans une ligne bifilaire, inséré entre un premier tronçon de ligne et un second tronçon de ligne relié à une charge et comprenant un premier dipôle en parallèle entre les fils de ligne incluant une résistance, est caractérisé en ce que le premier dipôle comprend, entre les deux fils de ligne, un condensateur en série avec la résistance.

Contrairement aux dispositifs de l'art antérieur cités précédemment, la localisation de coupures s'effectue, non pas par des mesures de résistance, mais par des mesures de capacité. L'utilisation d'un condensateur dans le premier dipôle évite toute exigence de polarisation de la ligne lorsque celle-ci est raccordée, par exemple pour une ligne téléphonique d'abonné à raccorder au joncteur du central téléphonique de rattachement. D'autre part, il n'y a aucune ambiguïté d'interprétation des mesures au cas où l'isolement de la ligne est imparfait. Par ailleurs, l'insertion du premier dipôle selon l'invention est compatible avec les appareils d'essais existant dans les centraux téléphoniques qui sont capables de mesurer des capacités.

Selon un autre aspect de l'invention, le dispositif comprend un second dipôle en série sur l'un des fils. Ce dipôle permet de distinguer des courts-circuits ou défauts d'isolement qui sont localisés dans les premier et second tronçons de ligne. Dans ce cas, les mesures pour localiser un défaut sont des mesures de résistance effectuées par l'appareil de mesures et d'essais à l'extrémité éloignée du premier tronçon de ligne. Le second dipôle se comporte comme une résistance variable qui est égale à une résistance prédéterminée dans une plage à courant faible et qui est très inférieure à cette résistance prédéterminée dans une plage à courant plus élevé contiguë à la plage à courant faible. Lors de l'exploitation normale de ligne, le courant circulant à travers celle-ci est inclus dans la plage à courant élevé afin que la perturbation conférée par le second dipôle soit pratiquement négligeable. Une tension appliquée par l'appareil de mesures correspondant à un courant dans la plage à courant faible permet de confirmer la présence d'un court-circuit ou analogue dans le second tronçon de ligne et la charge, lorsque la résistance mesurée a varié par rapport à celle mesurée pour un courant dans la plage à courant élevé.

Selon l'invention, le second dipôle peut comprendre de préférence une thermistance à coefficient de température négatif, ou deux diodes tête-bêche, ou deux voies parallèles dont l'une comprend un relais qui est en série avec un circuit composé d'une résistance en parallèle avec un contact de travail commandé par le relais et dont l'autre comprend un condensateur.

Le dispositif de localisation de défauts peut également comprendre un troisième dipôle analogue au second dipôle, en série sur l'autre fil de ligne.

D'autres avantages de la présente invention apparaîtront plus clairement à la lecture de la description qui suit de plusieurs modes de réalisation selon l'invention, en référence aux dessins annexés correspondants, dans lesquels:

— la fig. 1 montre schématiquement l'introduction d'un dispositif selon l'invention dans une ligne bifilaire;

— les fig. 2A et 2B montrent la structure du second ou troisième dipôle selon un premier mode de réalisation et sa caractéristique tension-courant;

— les fig. 3A et 3B montrent la structure du second ou troisième dipôle selon un second mode de réalisation et sa caractéristique tension-courant, et

— les fig. 4A et 4B montrent la structure du second ou troisième dipôle selon un troisième mode de réalisation et sa caractéristique tension-courant.

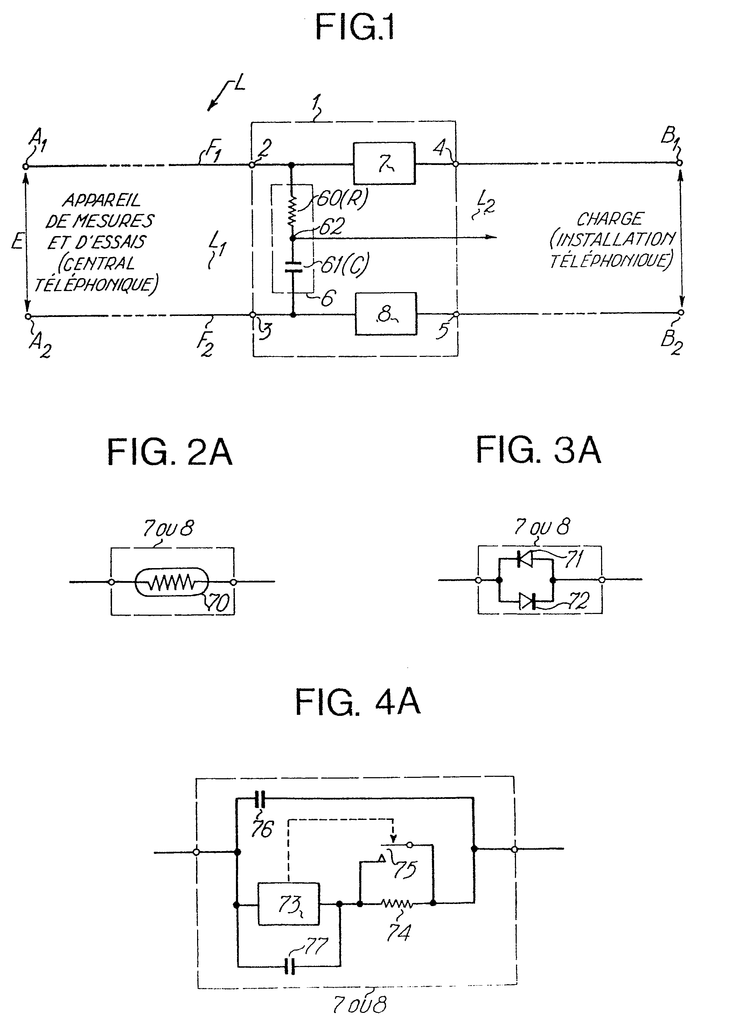

En se référant d'abord à la fig. 1, un mode de réalisation préféré du dispositif complet de localisation de défauts y est représenté. Il se présente sous la forme d'un quadripôle 1 qui est introduit dans une ligne L à deux fils conducteurs $F_1$ et $F_2$ et qui la partage en un premier tronçon $L_1$ et un second tronçon $L_2$. Le premier tronçon $L_1$ a l'une de ses extrémités qui est reliée sélectivement aux bornes $A_1$ et $A_2$ d'un appareil de mesures et d'essais et a son autre extrémité qui est reliée à des premières bornes parallèles 2 et 3 du quadripôle 1. Le second tronçon $L_2$ a l'une de ses extrémités qui est reliée aux deux autres bornes parallèles 4 et 5 du quadripôle 1, et a son autre extrémité qui est reliée aux bornes $B_1$ et $B_2$ d'une charge d'utilisation.

Selon une application préférée, lorsque la ligne bifilaire L est une ligne téléphonique d'abonné coaxiale ou à deux fils séparés, les bornes $A_1$ et $A_2$ sont reliées sélectivement à un appareil de mesures et d'essais qui est inclus dans le central téléphonique desservant la ligne. Les bornes $B_1$ et $B_2$ sont reliées à une installation téléphonique d'abonné. On se référera dans la suite à une telle application.

Selon le mode de réalisation montré à la fig. 1, le dispositif 1 comprend un premier dipôle 6 qui est interconnecté entre les bornes 2 et 3 du côté du central téléphonique, un second dipôle 7 qui est inséré entre les bornes 2 et 4 sur le premier fil de ligne $F_1$ et un troisième dipôle 8 qui est inséré entre les bornes 3 et 5 sur le second fil de ligne $F_2$.

Le premier dipôle 6 est en parallèle sur la ligne L et sert à localiser les coupures, appelées également ruptures ou ouvertures, sur l'un des fils ou sur les deux fils de ligne. Il est pourvu d'une résistance 60 et d'un condensateur 61 qui sont en série entre les bornes 2 et 3.

La valeur ohmique R de la résistance 60 et la valeur capacitive C du condensateur 61 sont choisies essentiellement en fonction de deux critères. La perturbation conférée par la présence du premier dipôle 6 doit être la plus faible possible au cours de l'exploitation normale de la ligne téléphonique afin que les courants circulant dans la ligne, pendant un appel de la sonnerie de l'installation téléphonique d'abonné ou pendant une conversation subissent un affaiblissement négligeable. Le second critère a trait au fait que la capacité apparente mesurée dans l'appareil de mesures du central entre les bornes $A_1$ et $A_2$ excède de manière flagrante la capacité propre de la ligne d'abonné L afin que les mesures de capacité distinguent la présence d'une coupure sur le premier tronçon $L_1$ par rapport à la présence d'une coupure sur le second tronçon $L_2$. Les valeurs optimales de R et C dépendent donc des caractéristiques extrêmes des lignes considérées et de l'appareil de mesures de capacité utilisé.

Par exemple, pour des câbles téléphoniques dont la capacité linéique est de 50 nF/km et dans un réseau téléphonique où aucune ligne d'abonné n'a une longueur excédant 20 km, la capacité propre de toute ligne d'abonné sera inférieure à 1 µF. Le couple résistif et capacitif 60-61 est choisi de telle manière que l'augmentation apparente de capacité due au dipôle 6 soit au moins 1 µF. Si l'appareil de mesures de capacité utilisé est fondé sur la mesure de la constante de temps de décharge de la ligne à travers une résistance de 20 kΩ, il suffit de prendre R=20 kΩ et C=2 µF pour que la capacité mesurée depuis l'entrée de toute ligne d'abonné soit augmentée d'au moins 1 µF en raison de la présence de ce premier dipôle 6 en parallèle sur la ligne. Dans ces conditions, en cas de coupure de la ligne, il suffit d'effectuer une mesure de capacité depuis les bornes $A_1$, $A_2$ du central. Si la capacité mesurée dépasse 1 µF, cela signifie que la coupure est au-delà du premier dipôle 6: la coupure est localisée dans l'ensemble composé du second tronçon de ligne $L_2$ et de la charge, ici l'installation téléphonique d'abonné. A cet égard, on notera que la longueur du second tronçon $L_2$ peut être très petite, voire négligeable, lorsque les bornes 4 et 5 sont pratiquement confondues avec les bornes $B_1$ et $B_2$ de l'entrée de l'installation téléphonique d'abonné. Par contre, si la capacité mesurée est inférieure à 1 µF, la coupure est en deçà du dispositif 1 et est donc localisée dans le premier tronçon $L_1$ de la ligne entre les bornes $A_1$, $A_2$ du central et les bornes 2, 3 du dipôle 6. La valeur capacitive effectivement mesurée permet d'ailleurs d'avoir alors une détermination approchée de la localisation de la coupure dans la ligne.

Les second et troisième dipôles 7 et 8 sont insérés en série respectivement sur les fils de ligne $F_1$ et $F_2$ et sont analogues. Ils sont destinés à localiser des courts-circuits, appelés également défauts d'isolement ou shunts à faible résistance, entre les deux fils de ligne ou entre l'un des fils de ligne et la terre.

L'invention prévoit trois types de tels dipôles ayant une résistance variable en fonction du courant qui est très faible pour les courants convoyés lors de l'exploitation normale de la ligne L.

Le premier type est montré à la fig. 2A et est constitué par une thermistance à coefficient de température négatif (CTN) 70.

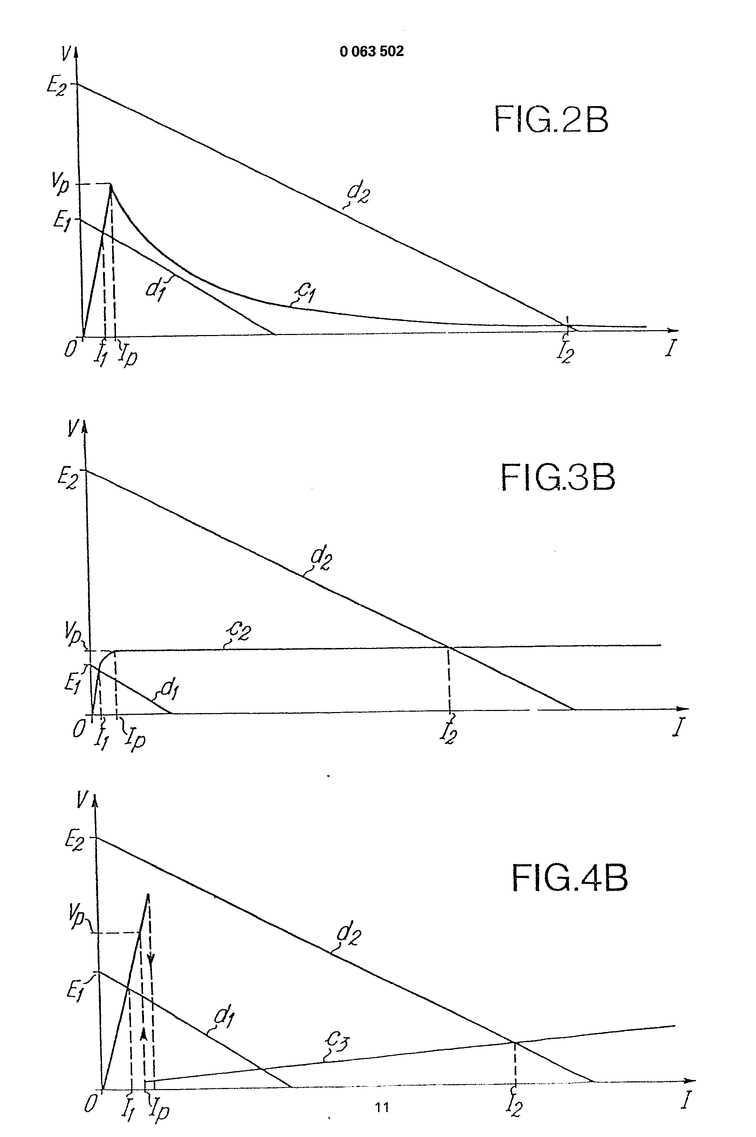

Le second type est montré à la fig. 3A et est constitué par deux diodes 71 et 72 qui sont montées en parallèle et tête-bêche.

Le troisième type est montré à la fig. 4A et est pourvu de deux voies parallèles. Une première voie comprend un relais 73 dont la bobine est en série avec un circuit composé d'une résistance 74 en parallèle avec un contact de travail 75 dont la fermeture est commandée par la mise au travail du relais. Cette première voie est shuntée par un condensateur 76 dans la seconde voie. Le condensateur 76 rend transparent le dipôle au courant alternatif ou impulsionnel. A ce condensateur 76 peut être substitué ou adjoint un second condensateur 77 qui est en parallèle entre les bornes de la bobine du relais 73 et qui joue à peu près le même rôle. Le relais 73 peut être un interrupteur à lames souples.

On rappelle qu'un interrupteur à lames souples, appelé également Relais Reed, se présente sous la forme d'une ampoule de verre dans le vide où le gaz inerte de laquelle baigne le contact à lames ferromagnétiques 75 et autour de laquelle est enroulé le fil constituant la bobine 73 du relais. Parmi les avantages de l'emploi d'un interrupteur à lames souples, on peut citer une grande vitesse de commutation, une faible consommation en énergie et une construction simple et bon marché.

Conjointement aux fig. 2A, 3A et 4A, on a représenté dans les fig. 2B, 3B et 4B les caractéristiques de tension (V) en fonction du courant (1), $C_1$, $C_2$ et $c_3$, des premier, second et troisième types des second et troisième dipôles 7 et 8. Ces trois types de dipôle présentent une résistance prédéterminée élevée dans une première plage à faible courant, et une résistance faible, très inférieure à la résistance prédéterminée, dans une seconde plage à courant élevé dans laquelle sont incluses les amplitudes des courants habituels pour l'exploitation normale de la ligne téléphonique, hors phase de repos. Il en résulte que les conditions de raccordement des lignes téléphoniques, notamment celles qui sont en fonction de l'alimentation et de l'affaiblissement, ne sont que très peu modifiées par la présence d'un second ou troisième dipôle. Par contre, les résultats des mesures de résistance de boucle dans la ligne, ou d'isolement d'un fil de ligne par rapport à la terre, sont sensiblement modifiés en fonction de la tension de mesure qui est appliquée par l'appareil de mesures et d'essais aux bornes $A_1$ et $A_2$ du côté du central téléphonique.

Dans les trois fig. 2B, 3B et 4B, les deux plages de courant précitées sont approximativement de part et d'autre d'une valeur de courant $I_p$, correspondant à une tension $V_p$, qui détermine le changement de pente ou le changement d'état des trois types de dipôle. Le point caractéristique ($I_p$, $V_p$) indique le seuil de basculement maximal de la valeur ohmique de la thermistance 70, le passage en régime linéaire des diodes 71 et 72 ou bien encore la mise au travail du relais 73 commandant la fermeture du contact 75 pour shunter la résistance 74. Bien entendu, les valeurs $I_p$ et $V_p$ sont généralement différentes dans les fig. 2B, 3B et 4B et dépendent des caractéristiques des composants inclus dans chacun des premier, second et troisième types de dipôle, respectivement.

Dans les fig. 2B, 3B et 4B sont également représentées deux droites $d_1$ et $d_2$ qui illustrent, vue des bornes 2 et 4 du dipôle 7, respectivement 3 et 5 du dipôle 8, la caractéristique $V(I) = E - rI$ de l'ensemble comprenant l'appareil de mesures, la ligne L et le défaut d'isolement considéré lorsque ce dernier est situé sur le deuxième tronçon de ligne $L_2$.

Dans le cas de la localisation d'un défaut d'isolement entre le fil $F_1$ (respectivement $F_2$) et la terre, E est la tension appliquée par l'appareil de mesures entre la borne $A_1$ (respectivement $A_2$) et la terre, et r est la somme de la résistance de l'appareil de mesures et de celle du fil $F_1$ (respectivement $F_2$) augmentée de la résistance du défaut d'isolement à la terre de ce fil.

Dans le cas de la localisation d'un défaut d'isolement entre les fils $F_1$ et $F_2$, et en raison de la présence des deux dipôles identiques 7 et 8 sur la boucle constituée par le défaut d'isolement lorsqu'il est situé sur le tronçon de ligne $L_2$, E est la moitié de la tension appliquée par l'appareil de mesures entre les bornes $A_1$ et $A_2$, et r est la moitié de la somme de la résistance de l'appareil de mesures, de la résistance de la ligne (et donc pratiquement la résistance de l'un de ses fils) et de la moitié de la résistance du défaut d'isolement.

La première droite $d_1$ est à considérer lorsque est appliquée une tension de mesure $E_1$ pour laquelle le dipôle fonctione dans la première plage à courant faible, en raison des valeurs de $E_1$ et de r. La droite $d_1$ coupe la caractéristique c en un point correspondant à un courant $I_1$, tel que $0 < I_1 \leqslant I_p$.

La seconde droite $d_2$ est effective lorsque est appliquée une tension de mesure $E_2$ pour laquelle le dipôle fonctionne dans la seconde plage à courant plus élevé, en raison des valeurs de $E_2$ et de r. La droite $d_2$ coupe la caractéristique c en un point correspondant à un courant $I_2$, tel que $I_p \ll I_2$.

Dans ces conditions, la distinction entre un court-circuit localisé dans le premier tronçon de ligne $L_1$ et un court-circuit localisé dans le second tronçon de ligne $L_2$ ou dans la charge est fondée sur la mesure des valeurs ohmiques du quotient E/I pour les tensions de mesure $E_1$ et $E_2$. Après avoir constaté, par l'application de la tension $E_2$, que la résistance mesurée correspond à la présence d'un court-circuit ou analogue, la tension de mesure $E_1$ est ensuite appliquée aux bornes $A_1$ et $A_2$. Si la valeur de la résistance précédemment mesurée ne varie pratiquement pas, cela signifie que la présence du ou des dipôles 7, 8 n'influence pas la mesure et que, par conséquent, le court-circuit ou analogue est localisé sur le premier tronçon de ligne $L_1$, du côté de l'appareil de mesures, entre les bornes $A_1$, $A_2$ et les bornes 2, 3. Par contre, si la résistance mesurée sous la tension $E_1$ a augmenté par rapport à celle mesurée précédemment sous la tension $E_2$, cela signifie que le courant traverse l'un ou l'autre ou les deux dipôles 7, 8. Il en résulte que le défaut est localisé dans le second tronçon de ligne $L_2$ ou dans la charge.

Selon l'invention, pour une ligne téléphonique, la perturbation conférée par l'un des dipôles ou les dipôles 7, 8 est négligeable lorsque les composants d'un tel dipôle sont choisis de telle sorte que le courant $I_p$ n'est pas inclus dans la plage normale du courant de fonctionnement — hors repos — d'une installation téléphonique d'abonné. De préférence, le courant $I_p$ est inférieur ou approximativement égal à 5 mA. Par ailleurs, l'augmentation de résistance lors de la mesure sous la tension $E_1$ doit être suffisamment importante pour être observée sans ambiguïté, ce qui conduit à choisir un rapport $V_p/I_p$, c'est-à-dire une résistance du dipôle dans la plage du courant faible ($I < I_p$) de l'ordre de 1 kΩ par exemple.

La tension $V_p$ est choisie de l'ordre de quelques volts lorsque le ou les deux dipôles 7, 8 sont du premier type comportant une thermistance 70 (fig. 2A) ou du troisième type comportant un relais 73 (fig. 4A); elle est déterminée par la nature de la

jonction des diodes utilisées, lorsque le ou les dipôles sont du second type (fig. 3A). Toutefois, pour ce second type de dipôle, il est possible d'obtenir un multiple entier de la tension $V_p$ correspondant à un simple jeu de diodes tête-bêche, en mettant en série plusieurs dipôles élémentaires du second type.

Le choix entre les différents types de dipôles 7, 8 et l'optimisation des valeurs $V_p$ et $I_p$ sont guidés en fonction des normes édictées pour la construction et la maintenance du système terminal d'abonné et en fonction des caractéristiques d'environnement des lignes d'abonné considérées. En outre, des couples $E_1$, $E_2$ différents peuvent être choisis suivant qu'il s'agit d'une mesure d'isolement entre un fil de ligne $L_1$ ou $L_2$ et la terre, ou entre les deux fils de ligne $L_1$ et $L_2$. Cela tient compte du fait qu'un seul dipôle 7 ou 8 intervient dans le cas d'une mesure d'isolement par rapport à la terre alors que les deux dipôles 7 et 8 interviennent dans le cas d'une mesure entre les deux fils de ligne, et du fait que les plages de mesures dans ces deux types d'essais sont éventuellement différentes.

Enfin, on notera que d'autres modes de réalisation du dispositif de localisation peuvent être envisagés à partir de celui décrit précédemment sans sortir du cadre de l'invention défini par les revendications annexées et sans modifier les principes de fonctionnement et de mesure exposés ci-dessus.

Bien que les second et troisième dipôles 7, 8 tels qu'illustrés dans la fig. 1 soient du côté de la charge, dans le second tronçon de ligne $L_2$, il peut être également envisagé que l'un ou les deux dipôles soient insérés dans le premier tronçon de ligne, côté appareil de mesures et d'essais entre les bornes $A_1$, $A_2$ et le premier dipôle 6. Cependant, la première réalisation est préférée, car la présence du ou des dipôles 7, 8 côté appareil de mesures intervient alors dans la mesure de capacité pour localiser une coupure en ligne.

En ce qui concerne le second type de dipôle, comprenant des diodes 71, 72, il peut être également envisagé de remplacer les deux diodes tête-bêche 71, 72 ou une série de telles diodes tête-bêche par une simple diode ou une série de simples diodes. Si le dispositif comporte de tels dipôles à diodes simples, les diodes sont conductrices suivant la même direction d'un courant circulant dans la ligne et bouclé à travers la charge. Cependant, cette dernière réalisation a l'inconvénient d'imposer une polarisation prédéterminée des tensions de mesure appliquées aux bornes $A_1$ et $A_2$, et des tensions appliquées lors de son exploitation normale.

Le dispositif de localisation ne peut comporter que le premier dipôle 6, ou le premier dipôle 6 et l'un des dipôles 7 et 8. Lorsque le dispositif comporte l'un des second et troisième dipôles 7, 8, la perturbation due à l'insertion du dipôle dans la ligne est avantageusement divisée par deux par rapport à la réalisation générale montrée à la fig. 1. Cependant, la localisation de défauts d'isolement par rapport à la terre est abandonnée pour le fil de ligne ne comportant pas un dipôle, 7 ou 8, tandis que la localisation de défauts d'isolement entre l'autre fil de ligne et la terre ou entre les deux fils de ligne est maintenue.

Pour l'application particulière à une charge telle qu'une installation téléphonique comportant une ou plusieurs sonneries d'appel, la borne 62 commune à la résistance 60 et au condensateur 61, montrée à la fig. 1, peut être reliée directement à l'une des bornes de la ou des sonneries d'appel. Le condensateur 61 joue le rôle supplémentaire d'un moyen de découplage en continu de la ou des sonneries d'appel de l'installation téléphonique.

Par ailleurs, plusieurs dispositifs de localisation selon l'invention, éventuellement identiques, peuvent être insérés en des points différents d'une ligne à deux fils conducteurs afin d'obtenir des localisations séparées de défauts dans chacun des tronçons de ligne ainsi délimités.

Supposons que deux dispositifs complets de localisation identiques soient insérés dans une ligne téléphonique d'abonné. Chacun de ces dispositifs provoque une augmentation apparente de capacité de 1 $\mu$F et une variation apparente de résistance de 1 k$\Omega$, en deux points de la ligne téléphonique; par exemple, le premier dispositif est au point de connexion représenté par le répartiteur du central téléphonique desservant la ligne, et le deuxième dispositif est à l'interface entre la ligne téléphonique et l'installation intérieure d'abonné.

Lors d'une coupure en ligne, si la capacité mesurée est inférieure à 1 $\mu$F, il en résulte que la coupure est entre l'appareil de mesures et d'essais et le répartiteur, aucun des deux dispositifs de localisation n'étant excité; si la capacité mesurée est comprise entre 1 et 2 $\mu$F, c'est que la coupure est dans la ligne entre le répartiteur et l'installation d'abonné, seul le premier des deux dispositifs de localisation étant excité; et si la capacité mesurée est supérieure à 2$\mu$F, la coupure est dans l'installation intérieure d'abonné puisque les deux dispositifs de localisation sont excités.

De même, lors d'une boucle ou d'un court-circuit en ligne, si la variation de résistance entre une mesure de résistance à très faible courant et une mesure de résistance à courant notablement supérieur est nulle, le défaut est entre l'appareil de mesures et d'essais et le répartiteur; si la variation de résistance est de 1 k$\Omega$, le défaut est dans la ligne proprement dite; et si la variation de résistance est de 2 k$\Omega$, le défaut est dans l'installation intérieure d'abonné.

Comme dans le cas d'un seul dispositif de localisation, les mesures de résistances peuvent être remplacées par des mesures de courants sous tensions connues, ou de tensions sous courants connus.

**Revendications :**

1. Dispositif de localisation (1) de défauts dans une ligne bifilaire, inséré entre un premier tronçon de ligne $(L_1)$ et un second tronçon de ligne $(L_2)$

relié à une charge (B) et comprenant un premier dipôle (6) en parallèle entre les fils de ligne ($F_1$, $F_2$) incluant une résistance (60), caractérisé en ce que le premier dipôle (6) comprend entre les deux fils de ligne ($F_1$, $F_2$) un condensateur (61) en série avec la résistance (60).

2. Dispositif conforme à la revendication 1, caractérisé en ce que la capacité du condensateur (61) est approximativement égale à 2 μF et la résistance (60) est approximativement égale à 20 kΩ

3. Dispositif conforme à l'une des revendications 1 ou 2, caractérisé en ce que la borne (62) commune à la résistance (60) et au condensateur (61) est reliée à l'une des bornes de la ou des sonneries d'appel d'une installation téléphonique remplaçant la charge (B).

4. Dispositif conforme à l'une des revendications 1 à 3, comprenant un second dipôle (7) en série sur l'un des fils de ligne, caractérisé en ce que le second dipôle (7) présente une résistance prédéterminée dans une plage à courant faible ($I_1 \leqslant I_p$) et une résistance inférieure à ladite résistance prédéterminée dans une plage à courant plus élevé ($I_2 > I_p$) contiguë à la plage à courant faible.

5. Dispositif conforme à la revendication 4, caractérisé en ce que le courant ($I_p$) intermédiaire entre les deux plages de courant est inférieur ou approximativement égal à 5 mA.

6. Dispositif conforme à l'une des revendications 4 ou 5, caractérisé en ce que la résistance prédéterminée est de l'ordre du kΩ.

7. Dispositif conforme à l'une des revendications 4 à 6, caractérisé en ce que le second dipôle (7) comprend une thermistance à coefficient de température négatif (70).

8. Dispositif conforme à l'une des revendications 4 à 6, caractérisé en ce que le second dipôle (7) comprend deux diodes tête-bêche (71, 72).

9. Dispositif conforme à l'une des revendications 4 à 6, caractérisé en ce que le second dipôle (7) comprend une diode (71 ou 72).

10. Dispositif conforme à l'une des revendications 4 à 6, caractérisé en ce que le second dipôle (7) comprend un relais dont la bobine (73) est en série avec un circuit composé d'une résistance (74) en parallèle avec un contact de travail (75) commandé par le relais.

11. Dispositif conforme à la revendication 10, caractérisé en ce que le second dipôle (7) comprend en parallèle entre ses bornes un condensateur (76).

12. Dispositif conforme à l'une des revendications 10 ou 11, caractérisé en ce que le second dipôle (7) comprend un condensateur (77) en parallèle entre les bornes de la bobine du relais (73).

13. Dispositif conforme à l'une des revendications 4 à 12, caractérisé en ce qu'il comprend plusieurs seconds dipôles (7) en série sur ledit fil de ligne ($F_1$).

14. Dispositif conforme à l'une des revendications 4 à 13, caractérisé en ce que le second dipôle (7) est inséré dans le second tronçon de ligne ($L_2$) entre le premier dipôle (6) et la charge (B).

15. Dispositif conforme à l'une des revendications 4 à 14, caractérisé en ce qu'il comprend un troisième dipôle (8) analogue au second dipôle (7), en série sur l'autre fil de ligne ($F_2$).

16. Système pour localiser des défauts dans une ligne bifilaire (L), caractérisé en ce qu'il comprend plusieurs dispositifs de localisation (1) conformes à l'une des revendications 1 à 15 et insérés à différents endroits dans la ligne (L).


**Patentansprüche:**

1. Anordnung zur Fehlerortung (1) auf einer zweiadrigen Leitung, die zwischen einer ersten Leitungsstrecke ($L_1$) und einer zweiten Leitungsstrecke ($L_2$) geschaltet und mit einer Ladung (B) verbunden ist und die einen ersten zwischen die Adern ($F_1$, $F_2$) parallelgeschalteten Dipol (6), der einen Widerstand (60) hat, umfasst, dadurch gekennzeichnet, dass der erste Dipol (6) zwischen den Adern ($F_1$, $F_2$) einen mit dem Widerstand (60) reihengeschalteten Kondensator (61) aufweist.

2. Anordnung nach Anspruch 1, dadurch gekennzeichnet, dass die Kapazität des Kondensators (61) ungefähr 2 μF beträgt, und der Widerstand (60) ungefähr 20 Ω hat.

3. SAnordnung nach einem der beiden Ansprüche 1 oder 2, dadurch gekennzeichnet, dass eine dem Widerstand (60) und dem Kondensator (61) gemeinsame Klemme (62) mit einer der Klemmen der Klingeleinrichtungen einer Fernsprechanlage, stellvertretend für die Ladung (B), verbunden ist.

4. Anordnung nach einem der Ansprüche 1 bis 3, die eine zweiten auf einer der Adern reihengeschalteten Dipol (7) besitzt, dadurch gekennzeichnet, dass der zweite Dipol (7) in der Schwachstromzone ($I_1 \leqslant I_p$) einen vorbestimmten Widerstand hat, während in einer Zone mit höherem Strom ($I_2 > I_p$), die an die Schwachstromzone angrenzt, der Widerstand niedriger als der genannte vorbestimmte Widerstand ist.

5. Anordnung nach dem Anspruch 4, dadurch gekennzeichnet, dass der zwischen den beiden Zonen liegende Strom ($I_p$) ungefähr 5 mA beträgt oder niedriger ist.

6. Anordnung nach einem der beiden Ansprüche 4 oder 5, dadurch gekennzeichnet, dass der vorbestimmte Widerstand in der Grössenordnung von Kiloohm liegt.

7. Anordnung nach einem der Ansprüche 4 bis 6, dadurch gekennzeichnet, dass der zweite Dipol (7) einen Thermistor mit negativem Temperaturkoeffizient (70) hat.

8. Anordnung nach einem der Ansprüche 4 bis 6, dadurch gekennzeichnet, dass der zweite Dipol (7) zwei Schutzdioden (71, 72) hat.

9. Anordnung nach einem der Ansprüche 4 bis 6, dadurch gekennzeichnet, dass der zweite Dipol (7) eine Diode (71 oder 72) hat.

10. Anordnung nach einem der Ansprüche 4 bis 6, dadurch gekennzeichnet, dass der zweite Dipol (7) ein Relais hat, dessen Spule (73) mit einem Stromkreis reihengeschaltet ist, der aus einem mit einem relaisgesteuerten Arbeitskontakt (75) parallelgeschalteten Widerstand (74) besteht.

11. Anordnung nach Anspruch 10, dadurch gekennzeichnet, dass der zweite Dipol (7) einen zwischen seine Klemmen parallelgeschalteten Kondensator (76) hat.

12. Anordnung nach einem der beiden Ansprüche 10 oder 11, dadurch gekennzeichnet, dass der zweite Dipol (7) einen zwischen die Klemmen der Relais-Spule (73) parallelgeschalteten Kondensator (77) hat.

13. Anordnung nach einem der Ansprüche 4 bis 12, dadurch gekennzeichnet, dass sie mehrere zweite auf der genannten Ader $(F_1)$ reihengeschaltete Dipole (7) hat.

14. Anordnung nach einem der Ansprüche 4 bis 13, dadurch gekennzeichnet, dass der zweite Dipol (7) in die zweite Leitungsstrecke $(L_2)$ zwischen dem ersten Dipol (6) und der Ladung (B) geschaltet ist.

15. Anordnung nach einem der Ansprüche 1 bis 14, dadurch gekennzeichnet, dass sie einen dritten, dem zweiten Dipol (7) analogen und auf der anderen Ader $(F_2)$ reihengeschalteten Dipol (8) hat.

16. System zur Fehlerortung auf einer zweiadrigen Leitung (L), dadurch gekennzeichnet, dass es mehrere, nach einem der Ansprüche 1 bis 15 und an verschiedenen Stellen der Leitung (L) angebrachte Anordnungen zur Fehlerortung (1) aufweist.

## Claims:

1. Device (1) for locating faults in a two-lead line, said device being interconnected between a first line section $(L_1)$ and a second line section $(L_2)$ connected to a load (B) and comprising a first dipole (6) parallel-connected between the line leads $(F_1, F_2)$ and including a resistor (60), characterized in that the first dipole (6) comprises between the two line leads $(F_1, F_2)$ a capacitor (61) connected in series with the resistor (60).

2. Device according to Claim 1, characterized in that the capacitance of the capacitor (61) is substantially equal to 2 µF and the resistor (60) is substantially equal to 20 kΩ.

3. Device according to Claim 1 or 2, characterized in that the terminal (62) common to the resistor (60) and the capacitor (61) is connected to one of the terminals of the ringing bell or bells of a telephone installation replacing the load (B).

4. Device according to one of Claims 1 to 3, comprising a second dipole (7) series-connected on one of the line leads, characterized in that the second dipole (7) has a predetermined resistance in a low-current region $(I_1 \leq I_p)$ and a resistance lower than said predetermined resistance in a higher-current region $(I_2 > I_p)$ adjacent the low-current region.

5. Device according to Claim 4, characterized in that the intermediate current $(I_p)$ between the two current regions is less than or substantially equal to 5 mA.

6. Device according to Claim 4 or 5, characterized in that the value of the predetermined resistance is substantially equal to one kΩ.

7. Device according to one of Claim 4 to 6, characterized in that the second dipole (7) comprises a negative temperature-coefficient thermistor (70).

8. Device according to one of Claims 4 to 6, characterized in that the second dipole (7) comprises two oppositely poled diodes (71, 72).

9. Device according to one of claims 4 to 6, characterized in that the second dipole (7) comprises a diode (71 or 72).

10. Device according to one of Claims 4 to 6, characterized in that the second dipole (7) comprises a relay whose coil (73) is connected in series with a circuit including a resistor (74) connected in parallel with a make contact (75) controlled by the relay.

11. Device according to Claim 10, characterized in that the second dipole (7) comprises a capacitor (76) parallel-connected between its terminals.

12. Device according to Claim 10 or 11, characterized in that the second dipole (7) comprises a capacitor (77) parallel-connected between the terminals of the relay coil(73).

13. Device according to one of Claims 4 to 12, characterized in that it comprises several second dipoles (7) series-connected on said line lead $(F_1)$.

14. Device according to one of Claims 4 to 13, characterized in that the second dipole (7) is inserted in the second line section $(L_2)$ between the first dipole (6) and the load (B).

15. Device according to one of Claims 4 to 14, characterized in that it comprises a third dipole (8) analogous to the second dipole (7), series-connected on the other line lead $(F_2)$.

16. System for locating faults in a two-lead line (L), characterized in that it comprises several locating devices (1) according to one of Claims 1 to 15 and inserted at various points in the line (L).

0 063 502

# FIG.1

APPAREIL
DE MESURES
ET D'ESSAIS
(CENTRAL
TÉLÉPHONIQUE)

CHARGE
(INSTALLATION
TÉLÉPHONIQUE)

# FIG. 2A

# FIG. 3A

# FIG. 4A

9

FIG.2B

FIG.3B

FIG.4B